# EUROPÄISCHE PATENTANMELDUNG

(11) **EP 4 756 863 A2**
(43) Veröffentlichungstag der Anmeldung: **10.06.2026**
(21) Anmeldenummer: 25218627.5
(22) Anmeldetag: 26.11.2025
(51) Int. Cl.: H01J 37/32

(54) **HOCHFREQUENZBEHANDLUNGSANLAGE, BEHANDLUNGSSTATION SOWIE VERFAHREN ZUR EINRICHTUNG EINER HOCHFREQUENZBEHANDLUNGSANLAGE**

(30) Priorität: 06.12.2024 DE 102024136499
(71) Anmelder: KHS GmbH, 44143 Dortmund (DE)
(72) Erfinder: Lengefeld, Jan, 44143 Dortmund (DE); Herbort, Michael, 44143 Dortmund (DE)
(74) Vertreter: Andrejewski - Honke Patent- und Rechtsanwälte Partnerschaft mbB

(57) **Zusammenfassung**

Die Erfindung betrifft eine Hochfrequenzbehandlungsanlage (1), insbesondere Plasmabehandlungsanlage, mit einer Behandlungsstation (2) zur Aufnahme eines Werkstücks (3) und mit einem an die Behandlungsstation (2) angeschlossenen Hochfrequenzgenerator (5) zur Erzeugung einer hochfrequenten elektromagnetischen Strahlung, insbesondere Mikrowellenstrahlung. Die Behandlungsstation (2) ist dazu eingerichtet, das Werkstück (3) mit einem Behandlungsraum (6) zu umschließen, in dem Behandlungsraum (6) eine Behandlungskonditionierung einzustellen und das Werkstück (2) unter der Behandlungskonditionierung durch Einwirkung der hochfrequenten Strahlung zu behandeln. Ausgehend von der gattungsgemäßen Hochfrequenzbehandlungsanlage (1) ist erfindungsgemäß vorgesehen, dass in dem Behandlungsraum (6) zumindest ein Ausfüllkörper (11) angeordnet ist.

## Beschreibung

Die Erfindung betrifft eine Hochfrequenzbehandlungsanlage, insbesondere Plasmabehandlungsanlage, mit einer Behandlungsstation zur Aufnahme eines Werkstücks und mit einem an die Behandlungsstation angeschlossenen Hochfrequenzgenerator zur Erzeugung einer hochfrequenten elektromagnetischen Strahlung, insbesondere Mikrowellenstrahlung. Die Behandlungsstation ist dazu eingerichtet, das Werkstück mit einem Behandlungsraum zu umschließen, in dem Behandlungsraum eine Behandlungskonditionierung einzustellen und das Werkstück unter der Behandlungskonditionierung durch Einwirkung der hochfrequenten Strahlung zu behandeln. Die Erfindung betrifft außerdem eine Behandlungsstation sowie ein Verfahren zur Einrichtung einer Hochfrequenzbehandlungsanlage.

Die Behandlungsstation stellt mehrere Funktionen bei der Behandlung des Werkstücks zur Verfügung. Durch das Umschließen des Werkstücks wird eine Abtrennung gegenüber der Umgebung gewährleistet, sodass eine Behandlungskonditionierung eingestellt werden kann. Andererseits ermöglicht die Behandlungsstation eine elektromagnetische Abschirmung, sodass das Werkstück in einer Kavität eingeschlossen ist. Infolgedessen kann die elektromagnetische Strahlung gezielt dem Werkstück zugeführt werden. Insbesondere wird durch den Einschluss der elektromagnetischen Strahlung ein Energieverlust vermieden und die Wirkung der Strahlung auf das Innere der Behandlungsstation beschränkt. So kann die elektromagnetische Strahlung direkt oder indirekt auf das Werkstück wirken.

Bei der Hochfrequenzbehandlung kann es sich insbesondere um eine Mikrowellen-induzierte Plasmabehandlung, wie beispielsweise eine Mikrowellen-induzierte Beschichtung, handeln. In diesem Fall bezieht sich die Erfindung auf eine Plasmabehandlungsanlage. Ganz bevorzugt bezieht sich die Erfindung auf die Plasmabeschichtung von Kunststoffbehältern, welche insbesondere aus Polyethylenterephthalat (PET) gebildet sind.

Die Behandlungskonditionierung kann durch unterschiedliche physikalische Parameter und oder die stoffliche Zusammensetzung eines Mediums charakterisiert sein, welches in der Behandlungsstation mit dem Werkstück in Kontakt tritt. Die physikalischen Parameter der Behandlungskonditionierung können insbesondere die Temperatur, den Druck und/oder die Dichte umfassen. Über die Parameter können elektrische Leitungseigenschaften bzw. die Zündfähigkeit eines Plasmas innerhalb der Behandlungsstation gesteuert werden.

Die stoffliche Zusammensetzung des Mediums - auch als Behandlungsatmosphäre bezeichnet - ist insbesondere auf den gewählten Hochfrequenz-behandlungsprozess abgestimmt. So kann es sich beispielsweise bei dem Medium um Luft, ein oder mehrere Inertgase sowie Mischungen daraus handeln. Auch können in dem Medium chemisch und/oder physikalisch reaktive und/oder veränderliche Stoffe als sogenanntes Reaktionsgas enthalten sein. Hierbei kann es sich beispielsweise für einen Plasmaabscheidungsprozess bzw. Plasmabeschichtungsprozess um sogenannte Monomere handeln. Diese werden unter Einwirkung der hochfrequenten elektromagnetischen Strahlung verändert. Beispielsweise kann es sich um einen PIVCD-Prozess (Plasma Induced Chemical Vapour Deposition) handeln, bei dem aus einem Reaktionsgas Moleküle aufgespalten werden, welche sich schichtartig an dem Werkstück ablagern und so eine gleichförmige dünne Beschichtung bilden.

Um ihre Funktionen erfüllen zu können, muss die Behandlungsstation eine ausreichende mechanische Stabilität aufweisen. Dies gilt insbesondere, wenn die Behandlungskonditionierung durch einen Unter- oder Überdruck gekennzeichnet ist. Ebenso ist eine Unempfindlichkeit gegen den chemischen Komponenten der Behandlungsatmosphäre und/oder der hochfrequenten Strahlung erforderlich.

Gleichzeitig muss die hochfrequente elektromagnetische Strahlung auf die Geometrie der Behandlungsstation abgestimmt werden, um innerhalb der geschlossenen Kavität eine gewünschte Strahlungsverteilung zu erzielen. Damit diese Abstimmung nicht bei einer veränderten Geometrie des Werkstücks neu vorgenommen werden muss, sind Behandlungsstationen üblicherweise großzügig dimensioniert. Dadurch können a priori vielfältige Typen und Abmessungen von Werkstücken aufgenommen werden. So sind die Behandlungsstationen jedoch oft für das konkret verwendete Werkstück überdimensioniert.

Hochfrequenz meint im Rahmen der Erfindung einen Frequenzbereich von zumindest 1kHz, insbesondere zumindest 10 kHz. In einem besonders bevorzugten Aspekt betrifft die Erfindung eine Behandlung mit Mikrowellen in einem Frequenzbereich zwischen 1 GHz und 300 GHz und einer Wellenlänge im Bereich von etwa 30 cm und 1 mm.

Neben den zusätzlichen Material- und Betriebskosten für die Behandlungsstation aufgrund der größeren Abmessungen ergibt sich während der Verwendung zusätzlich die Schwierigkeit, dass beim Einsetzen des Werkstücks in dem Behandlungsraum sowie beim Entnehmen des Werkstücks aus dem Behandlungsraum im Anschluss an die Behandlung die Behandlungskonditionierung verloren geht und sich die Bedingungen in dem Behandlungsraum an die Umgebungsbedingungen angeglichen werden. Mit der Größe der Behandlungsstation steigt jedoch auch der Aufwand für jeden Behandlungszyklus erneut die Behandlungskonditionierung einzustellen - insbesondere ein benötigtes Druckniveau und/oder Stoffzusammensetzung. Hierdurch werden nicht nur Energie und Ressourcen verbraucht sondern auch Zeit verwendet. Insbesondere bei Einsatzszenarien, bei denen das Volumen des Werkstücks besonders klein im Verhältnis zum umschlossenen Volumen der Behandlungsstation steht, verlängern sich dadurch die Taktzeiten erheblich, sodass nur ein eingeschränktes Produktionstempo erreicht werden kann.

Vor diesem Hintergrund liegt der Erfindung die Aufgabe zugrunde, den Betrieb einer gattungsgemäßen Behandlungsanlage effizienter zu gestalten und eine Anpassung an beliebige Werkstücke zu ermöglichen. Gegenstand der Erfindung und Lösung dieser Aufgabe ist eine Behandlungsanlage nach Anspruch 1, eine Behandlungsstation nach Anspruch 3 sowie ein Verfahren nach Anspruch 17 Bevorzugte Ausgestaltungen sind jeweils in den abhängigen Unteransprüchen angegeben.

Ausgehend von der gattungsgemäßen Behandlungsanlage ist erfindungsgemäß vorgesehen, dass in der Behandlungsstation zumindest ein Ausfüllkörper angeordnet ist. Dieser hat in dem Hochfrequenz-Behandlungsprozess keine unmittelbare Wirkung auf das Werkstück, sondern reduziert lediglich den ungenutzten Totraum innerhalb der Behandlungsstation, in der die Behandlungskonditionierung angestrebt wird. Durch diese Reduktion kann die Behandlungskonditionierung mit einem geringeren Einsatz an Energie, Ressourcen und/oder Zeit eingestellt werden.

Vorzugsweise weist die Hochfrequenzbehandlungsanlage eine an die Behandlungsstation angeschlossene Konditionierungseinrichtung zur Herstellung der Behandlungskonditionierung in der Behandlungsstation auf. Diese ist dazu eingerichtet, ein beabsichtigtes Druckniveau und/oder eine gewünschte chemische Zusammensetzung des Mediums zumindest in Teilbereichen der Behandlungsstation herzustellen. Durch die Verwendung des erfindungsgemäßen Ausfüllkörpers kann die Konditionierungseinrichtung im Betrieb entlastet werden, da diese ein geringeres Volumen innerhalb der Behandlungsstation beschicken muss.

Die Konditionierungseinrichtung weist insbesondere ein Druckreservoir bzw. eine Druckquelle oder Drucksenke auf. Indem das Druckreservoir - welches ohne Beschränkung mit einem Über- bzw. Unterdruck gegenüber dem atmosphärischen Umgebungsdruck aufweisen kann - über eine steuerbare Leitung mit dem inneren der Behandlungsstation verbunden wird, kann ein Angleichen des dortigen Druckniveaus an das Druckreservoir erfolgen. Dieser Druckausgleich dauert umso länger, je mehr Medium aus der Behandlungsstation abgeführt bzw. in diese eingeleitet werden muss. Dieser Massenfluss lässt sich durch den erfindungsgemäßen Ausfüllkörper reduzieren.

Weiterhin weist die Konditionierungseinrichtung bevorzugt zumindest eine Zuleitungsanordnung für ein Prozessgas bzw. Reaktionsgas auf, durch welches frisches, unverbrauchtes Reaktionsgas dem Behandlungsraum zugeleitet werden kann. Ebenso kann auch eine dezidierte Ableitung für das Prozessgas vorgesehen sein. Mehrere Zu- und/oder Ableitungen zum Druckausgleich und zur Führung eines Reaktionsgases können auch miteinander verbunden bzw. einheitlich ausgeführt sein.

Das Reaktionsgas ist dazu vorgesehen mit der elektromagnetischen Strahlung - insbesondere infolge der Zündung eines Plasmas - zu reagieren. Bei einem als Hohlkörper ausgebildeten Werkstück mit einem Innenraum kann beispielsweise vorgesehen sein, dass ausschließlich dem Innenraum ein Reaktionsgas zugeleitet wird. Die reaktive Behandlung, d.h. das Zünden eines Plasmas und die Plasma-vermittelte Beschichtung erfolgen dann ausschließlich an der Innenseite des Hohlkörpers. Um eine mechanische Verformung zu vermeiden, kann die Behandlungskonditionierung dann an der Außenseite des Hohlkörpers ausschließlich einen Druckangleich an den Innenraum - insbesondere eine Evakuierung auf ein ähnliches oder gleiches Unterdruck-Niveau - umfassen. Analog kann eine Beschichtung auch ausschließlich außenseitig erfolgen oder sowohl innen-als auch außenseitig vorgesehen werden.

Gegenstand der Erfindung ist auch eine Behandlungsstation für eine Hochfrequenzbehandlungsanlage, wie diese zuvor beschrieben ist. Diese weist einen Behandlungsraum zur Aufnahme und Einhausung eines Werkstücks auf. Erfindungsgemäß ist zumindest ein Ausfüllkörper in dem Behandlungsraum angeordnet. Dadurch kann das effektive Volumen des Behandlungsraumes, in dem die Behandlungskonditionierung eingestellt werden muss reduziert werden. Dies ist insbesondere dann vorteilhaft, wenn das Werkstück ein geringes (umschlossenes) Volumen im Verhältnis zu dem Behandlungsraum aufweist.

Sämtliche nachfolgend beschriebenen Ausführungsformen der Behandlungsstation können insbesondere auch Teil einer erfindungsgemäßen Hochfrequenzbehandlungsanlage sein.

Gemäß einer bevorzugten Ausführungsform weist der Ausfüllkörper eine Außenfläche auf, welche an eine Innenfläche des Behandlungsraums geometrisch angepasst ist. Dadurch kann der Ausfüllkörper den Behandlungsraum möglichst effektiv und umfassend ausfüllen.

Insbesondere weist der Behandlungsraum eine zylindrische Grundform mit zu zumindest einer zylindersymmetrischen Seitenwand auf. Die zylindersymmetrische Seitenwand hat wiederum eine Innenfläche, welche zumindest abschnittsweise zylindermantelförmig um eine Längserstreckungsachse ausgebildet ist.

Als eine mögliche Variante einer angepassten Form des Ausfüllkörpers kann vorgesehen sein, dass diese zumindest eine zylindermantelförmige Außenfläche aufweist. Diese ist bevorzugt so angeordnet, dass die Symmetrieachse der Außenfläche mit der Längserstreckungsachse des Behandlungsraums fluchtet. Dadurch kann zwischen der zylindrischen Außenflächen der zylindrischen Innenfläche ein konstanter Spalt ausgebildet sein.

Besonders bevorzugt weist die Außenfläche zu der Innenfläche (zumindest) einen Abstand von weniger als 10 mm, vorzugsweise weniger als 5 mm, insbesondere weniger als 1 mm auf. Besonders bevorzugt beträgt der flächenmäßig gemittelte Abstand zwischen der Innenfläche der Außenfläche nicht mehr als 10 mm, vorzugsweise nicht mehr als 5 mm, insbesondere weniger als 1 mm. Ganz besonders bevorzugt beträgt der minimale Abstand zu zur Innenfläche an keinem Punkt der Außenfläche mehr als 10 mm, vorzugsweise nicht mehr als 5 mm, insbesondere nicht mehr als 1 mm. Alternativ oder zusätzlich ist vorgesehen, dass die Außenfläche zumindest teilweise, vorzugsweise vollständig an der Innenfläche anliegt.

Durch die Anpassung der Form der Außenfläche an die Innenfläche des Behandlungsraumes kann eine möglichst vollständige Ausfüllung desselben und infolgedessen ein besonders gutes erfindungsgemäßes Ergebnis erzielt werden. Ganz besonders bevorzugt weist der Ausfüllkörper mehrere Außenflächen auf, welche jeweils an zugeordneten Innenflächen des Behandlungsraums anliegen oder zu denen in einem geringen Abstand von nicht mehr als wenigen Millimetern angeordnet sind.

Gemäß einer besonders bevorzugten Ausgestaltung erstreckt sich, wenn in der Behandlungsstation ein Werkstück angeordnet ist, zwischen dem Werkstück und der Innenseite der Behandlungsstation ein Residualvolumen. Dieses füllt der Ausfüllkörper zu zumindest 10 %, vorzugsweise zumindest 50 %, besonders bevorzugt zumindest 75 %, insbesondere zwischen 80 % und 90 % aus. Das Residualvolumen bezieht sich dabei auf den Raum zwischen der Außenseite eines Werkstücks und der Innenseite des Behandlungsraums. Beispielsweise bei hohlen Werkstücken, z. B. Behältern, kann der Behälterinnenraum unberücksichtigt bleiben. Insbesondere bezieht sich das Residualvolumen auf den Raum zwischen der minimalen konvexen Hülle des Werkstücks und der Innenseite des Behandlungsraums.

Durch ein Ausfüllen des Residualvolumens um 50 % kann der Verbrauch an Ressourcen (Energie, Reaktionsgas etc.) und der Zeitverbrauch in etwa halbiert werden. Dadurch lässt sich der Hochfrequenzbehandlungsprozess effizienter und schneller umsetzen.

Gemäß einer besonders bevorzugten Ausgestaltung weist die Behandlungsstation eine sich einseitig in dem Behandlungsraum hinein erstreckende Werkstückaufnahme auf. Dabei kann es sich insbesondere um eine Halte- und Dichtvorrichtung zur Aufnahme der Mündung eines Behälterkörpers handeln. Gemäß einer bevorzugten Ausgestaltung der Erfindung ist der Ausfüllkörper an der der Werkstückaufnahme gegenüberliegenden Seite des Behandlungsraums angeordnet. Dadurch wird das freie Volumen innerhalb des Behandlungsraums in Richtung der Werkstückaufnahme und damit des Werkstücks hin verlagert.

Gemäß einer besonders bevorzugten Ausgestaltung ist die Werkstückaufnahme an einer Grundplatte angeordnet, welche gemeinsam mit einem Oberteil den Behandlungsraum umschließt. Das Oberteil des vorzugsweise relativ beweglich zu der Grundplatte vorgesehen, sodass der Behandlungsraum durch eine relative Verlagerung geöffnet und geschlossen werden kann. In diesem Fall ist der Ausfüllkörper besonders bevorzugt in dem Oberteil angeordnet und an diesem befestigt.

Besonders bevorzugt ist der Ausfüllkörper formschlüssig, insbesondere durch einen Bajonettverschluss und/oder eine Schraubverbindung in dem Behandlungsraum befestigt. Die formschlüssige Verbindung erlaubt eine sichere Aufnahme, insbesondere wenn der Ausfüllkörper und/oder weitere Teile der Behandlungsstation im Rahmen des Hochfrequenzbehandlungsprozesses bewegt werden.

Gemäß einer besonders bevorzugten Ausgestaltung ist der Ausfüllkörper starr ausgebildet. Dieser kann zur Erreichung einer einfachen Konstruktion in sich und insbesondere auch hinsichtlich eines Befestigungspunktes an dem Behandlungsraum unbeweglich ausgebildet sein. Der Ausfüllkörper muss keinerlei mechanische Funktion - neben dem Ausfüllen eines Volumens wahrnehmen und kann daher besonders einfach ausgestaltet sein.

Besonders bevorzugt ist der Ausfüllkörper hohl ausgebildet. Hohl meint dabei, dass im Inneren des Ausfüllkörpers ein oder mehrere Bereiche vorgesehen sind, welche nicht durch ein festes Material ausgefüllt sind. Insbesondere sind diese hohlen Bereiche mit einem gasförmigen Medium oder Mediengemisch wie beispielsweise Luft, einem Inertgas, Prozessgasen und dergleichen ausgefüllt. Neben den geringeren Materialkosten ist hierbei von Vorteil, dass auch eine Massenreduktion des Ausfüllkörpers stattfindet. Dieser lässt sich daher besonders einfach handhaben und fügt nur im geringen Maße träge Massen in das System der Behandlungsstation bzw. der Hochfrequenzbehandlungsanlage ein. Zusätzlich reduziert ein Hohlkörper - unabhängig von der Füllung - die Auswirkung auf das elektromagnetische Feld und damit die Ausbreitung der hochfrequenten elektromagnetischen Wellen.

Besonders bei kostengünstigen Materialien mit einer geringen Dichte kann der Ausfüllkörper auch durchgängig gebildet sein. Insbesondere kann er dabei aus einem thermoplastischen Material gegossen und/oder aus dem Vollmaterial durch spanende Bearbeitung geformt sein.

Besonders bevorzugt ist der Ausfüllkörper aus zumindest einem nicht-leitenden Material, insbesondere einem Kunststoffmaterial gebildet. Dies hat den Vorteil, dass das hochfrequente elektromagnetische Feld nur in geringem Maße verzerrt wird und die Mikrowellen sich im Wesentlichen wie bei einem Behandlungsraum ohne den Ausfüllkörper ausbreiten. Besonders bevorzugt ist als Material POM (Polyoxymethylene) oder PEEK (Polyetheretherketon) vorgesehen. Diese Materialien weisen auch eine günstige Dielektrizität, insbesondere im Wellenlängenbereich der Mikrowellen auf.

Bevorzugt weist der Ausfüllkörper eine abgeschlossene Hülle, insbesondere mit einer Wandstärke zwischen 1 mm und 5 mm auf. Innerhalb der Hülle ist der Ausfüllkörper hohl mit einem Materialfüllgrad von nicht mehr als 25 %, vorzugsweise nicht mehr als 10 % ausgebildet. Eine derartige Struktur ermöglicht einerseits einen vollständigen Einschluss des Volumens innerhalb des Ausfüllkörpers und andererseits eine besonders stabile und leichte Konstruktion. Das Material innerhalb der Hülle ist insbesondere als Stützstruktur ausgebildet, welche auftretende Kräfte zwischen den Flächen der Hülle abstützt bzw. ableitet.

Vorzugsweise ist der Ausfüllkörper in einem additiven Fertigungsverfahren hergestellt. Hierbei kann es sich beispielsweise um selektives Aufschmelzen aus einem pulvrigen Werkstoff, selektives Aushärten eines flüssigen Werkstoffes (insbesondere Kunstharz) und/oder Anordnen von aufgeschmolzenem Kunststoffmaterial (fused deposition modeling) hergestellt. Die additiven Fertigungsverfahren - im Allgemeinen auch als "3D-Druck" bezeichnet - eignen sich insbesondere eine besonders an die geometrischen Umstände - Form des Werkstücks und Form des Behandlungsraums und sowie darin hineinragende Einbauten - anzupassen und gleichzeitig eine stabile und leichte Konstruktion herzustellen.

Besonders bevorzugt weist der Ausfüllkörper eine Stützstruktur und eine materialverschiedene die Stützstruktur umschließende Beschichtung auf. Hierbei kann es sich um eine funktionale Trennung zwischen der mechanischen Integrität des Ausfüllkörpers und des (Druck-)dichten Abschlusses des Innenraums handeln. Die Stützstruktur ist insbesondere in einem zuvor beschriebenen additiven Fertigungsverfahren hergestellt mit einer Außenhülle und einer darin angeordneten Stützstruktur. Die Beschichtung ist als Dichtung vorgesehen und kann insbesondere nachträglich durch Aufsprühen, Tauchen und/oder physikalische oder chemische Veränderung des Materials der Stützstruktur hergestellt sein.

Ganz besonders bevorzugt weist der Ausfüllkörper zumindest eine Aussparung auf. Unter einer Aussparung ist insbesondere ein Minus gegenüber der minimalen konvexen Hülle des Formkörpers, welcher den Ausfüllkörper bildet, zu verstehen. Beispielsweise kann eine solche Aussparung dazu vorgesehen sein das Werkstück und/oder etwaige Einbauten innerhalb des Behandlungsraums - wie beispielsweise eine Halte- und Dichtvorrichtung - mit möglichst geringem Abstand zu umschließen.

Weiterhin kann die Aussparung auch dazu vorgesehen sein, während des Betriebs einen Durchlass für hochfrequente elektromagnetische Strahlung, das die Behandlungsatmosphäre bildenden Mediums und/oder Messsignale wie beispielsweise optische Signale zur Überwachung des Prozesses durchzulassen.

Gemäß einer besonders bevorzugten Ausgestaltung ist insbesondere im letzten Fall die Aussparung als Durchbruch ausgebildet, welcher sich durch den Formkörper hindurch erstreckt.

Besonders bevorzugt ist die Aussparung symmetrisch zu einer Symmetrieachse des Formkörpers/konzentrisch um eine Längserstreckungsachse angeordnet. Dadurch ist die Positionierung der Aussparung unabhängig von der konkreten Ausrichtung des Ausfüllkörpers.

In einer besonders einfachen Ausführungsform der Erfindung ist der Ausfüllkörper einteilig ausgebildet. Dies erleichtert die Herstellung und Montage sowie die spätere Handhabung.

Gemäß einer alternativen und auch bevorzugten Ausgestaltung kann der Ausfüllkörper auch mehrteilig modular mit zumindest einem ersten Ausfüllmodul und einem zweiten Ausfüllmodul gebildet sein. Durch den modularen Aufbau wird eine Anpassung an eine Vielzahl von Anwendungsszenarien bzw. Werkstückgeometrien vereinfacht.

Besonders bevorzugt liegen das erste Ausfüllmodul und das zweite Ausfüllmodul dabei aneinander an und sind bevorzugt aneinander befestigt. Somit wird ein virtueller Gesamtausfüllkörper gebildet, dessen Bestandteile besonders bevorzugt unabhängig voneinander austauschbar sind.

Ein weiterer Gegenstand der Erfindung ist ein Verfahren zum Einrichten einer Hochfrequenzbehandlungsanlage, insbesondere nach einem der Ansprüche 1 bis 2 mit einer insbesondere erfindungsgemäßen Behandlungsstation und mit einem mit der Behandlungsstation verbundenen Hochfrequenzgenerator. Gemäß der Erfindung ist vorgesehen, dass in Abhängigkeit von der Geometrie - insbesondere Größe, Abmessungen, Volumen, Formgebung - des Werkstücks zumindest ein Ausfüllkörper ausgewählt und/oder hergestellt wird und anschließend in die Behandlungsstation eingesetzt wird. Im Rahmen des erfindungsgemäßen Verfahrens wird der Totraum innerhalb der Behandlungsstation reduziert, innerhalb dessen eine Behandlungskonditionierung hergestellt werden muss. Dadurch können die Taktzeiten der Plasmabehandlung verkürzt und der Einsatz an Material und Energie reduziert werden.

Die Erfindung wird nachfolgend anhand von lediglich einer ein Ausführungsbeispiel darstellenden Figur erläutert. Diese zeigt schematisch einen Schnitt durch eine erfindungsgemäße Plasmabehandlungsanlage.

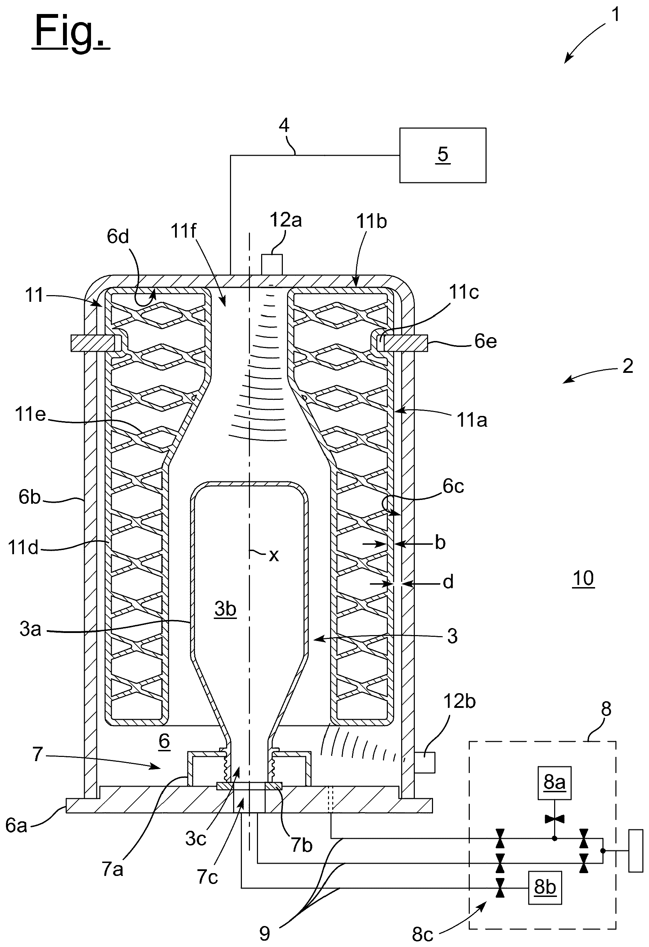

Die einzige Figur zeigt eine erfindungsgemäße Hochfrequenzbehandlungsanlage 1 mit einer Behandlungsstation 2 zur Aufnahme eines Werkstücks 3. Das Werkstück ist in dem gezeigten Ausführungsbeispiel als Behälter mit einem durch eine Behälterwandung 3a umschlossenen Behälterinnenraum 3b ausgebildet, der durch eine Behältermündung 3c zugänglich ist. Das Werkstück 3 ist im Wesentlichen rotationssymmetrisch um eine Längserstreckungsachse x ausgebildet.

An die Behandlungsstation 2 ist über einen Wellenleiter 4 ein Hochfrequenzgenerator 5 angeschlossen. In dem dargestellten Ausführungsbeispiel ist der Hochfrequenzgenerator als Magnetron zu Erzeugung von Mikrowellenstrahlung ausgebildet.

Die Behandlungsstation 2 weist einen Behandlungsraum 6 zum Aufnehmen und Umschließen des Werkstücks 3 auf. Der Behandlungsraum 6 ist mehrteilig mit einer Grundplatte 6a und einem entlang der Längserstreckungsachse x gegenüber der Grundplatte 6a bewegbaren Oberteil 6b gebildet. An der Grundplatte 6a ist eine Werkstückaufnahme 7 in Form einer Halte- und Dichtvorrichtung angeordnet, an der das Werkstück 3 gehalten werden kann. Dazu sind zwei Greifzangen 7a vorgesehen, welche das Werkstück 3 im Bereich der Mündung 3c umgreifen und gegen eine Dichtung 7b drücken. Die Dichtung 7b umschließt dabei eine zentrale Zugangsöffnung 7c.

Zur Einstellung einer Behandlungskonditionierung innerhalb des Behandlungsraums 6 umfasst die Hochfrequenzbehandlungsanlage 1 weiterhin eine Konditionierungseinrichtung 8, welche über Medienleitungen 9 mit dem Inneren des Behandlungsraums 6 verbunden. Dabei führen rein beispielhaft zwei Leitungen über die zentrale Zugangsöffnung 7c in den Behälterinnenraum 3b des Werkstücks 3, während eine weitere Medienleitung 9 in das das Werkstück 3 umgebende Volumen innerhalb des Behandlungsraums 6 führt.

Die dargestellte Konditionierungseinrichtung 8 weist beispielhaft zwei Versorgungseinheiten 8a, 8b auf, welche den Behandlungsraum 6 - außerhalb bzw. innerhalb des Werkstücks 3 - mit einem geeigneten Druck sowie einer vorgesehenen Reaktionsgas-Mischung versehen. Diese Zu- und Ableitung ist über Ventilanordnungen 8c steuerbar. Gleichsam wird über entsprechende Ventile der Ventilanordnungen 8c ein Druckausgleich mit der Umgebung 10 ermöglicht, um den Behandlungsraum 6 öffnen zu können.

In dem vorgesehenen Hochfrequenzbehandlungsverfahren wird ein Werkstück 3 zunächst in die Behandlungsstation 2 eingesetzt, indem der Mündungsbereich 3c in der Greifzange 7a aufgenommen wird. Anschließend wird das Oberteil 6b auf die Grundplatte 6a abgesenkt, sodass sich um das Werkstück 3 herum eine Kavität schließt.

Danach wird durch die Konditionierungseinrichtung 8 innerhalb des Behandlungsraums 6 die vorgesehene Behandlungskonditionierung hergestellt. Dazu wird insbesondere das Innere des Behandlungsraums 6 evakuiert und in den Behälterinnenraum 3b ein Reaktionsgas mit einem ebenfalls reduzierten Druckniveau eingeleitet. Nachfolgend wird eine Hochfrequenzbehandlung vorgenommen, in dem der Hochfrequenzgenerator 5 Mikrowellen erzeugt, welche über den Wellenleiter 4 der Kavität 6 zugeleitet werden. Infolgedessen zündet in dem Reaktionsgas innerhalb des Behälterinnenraums 3b ein Plasma, welches zu einer Plasma-induzierten Abscheidung von Beschichtungsmolekülen an der Innenseite des Werkstücks 3 führt.

Nach dem Abschluss des Beschichtungsprozesses wird mit der Umgebung 10 ein Druckausgleich hergestellt und die Kavität 6 durch Anheben des Oberteils 6b geöffnet, sodass das beschichtete Werkstück 2 entnommen werden kann.

Erfindungsgemäß ist in der Behandlungsstation 2, nämlich in dem Behandlungsraum 6 ein Ausfüllkörper 11 angeordnet. Dieser füllt einen überwiegenden Teil des Residualvolumens zwischen dem Werkstück 3 und der Innenseite des Behandlungsraums 6 aus.

Dabei weist der Ausfüllkörper 11 eine zylindrische Grundform mit einer um die Längserstreckungsachse x zylindersymmetrisch ausgebildete Außenfläche 11a auf. Diese ist an eine ebenfalls zylindersymmetrische Innenfläche 6c des Behandlungsraums 6 angepasst, welche ebenfalls zylindersymmetrisch um die Längserstreckungsachse x angeordnet ist. Zwischen der Außenfläche 11a und der Innenfläche 6c ist ein Abstand d ausgebildet, welche auf der gesamten Fläche weniger als 5 mm beträgt. Ebenso weist der Ausfüllkörper 11 eine kreisringförmige Stirnfläche 11b auf, welche an einer Deckenfläche 6d des Behandlungsraums 6 flächig anliegt.

Entsprechend ist der Ausfüllkörper 11 an einem der Werkstückaufnahme 7 der Behandlungsstation 2 gegenüberliegenden Ende des Behandlungsraums 6 angeordnet. Zur formschlüssigen Befestigung des Ausfüllkörpers 11 sind an der Innenseiten des Behandlungsraums 6 Verriegelungszapfen 6e ausgebildet, welche radial in Richtung der Längserstreckungsachse x nach innen vorstehen. Diese greifen in zugeordnete Verriegelungsaufnahmen 11c des Ausfüllkörpers 11 ein.

Der Ausfüllkörper 11 ist starr und in sich unbeweglichen ausgebildet. Durch die Verriegelung des Bajonettverschlusses ist er ebenfalls unbeweglich an dem Oberteil 6b des Behandlungsraums 6 gelagert und wird mit diesem gleichzeitig entlang der Längserstreckungsachse x bewegt.

Weiterhin ist Ausfüllkörper 11 in dem dargestellten Ausführungsbeispiel hohl ausgestaltet. Dabei weist der Ausfüllkörper 11 eine durchgängige Hülle 11d mit einer Wandstärke b von 5 mm auf. Innerhalb der Hülle 11d ist der Ausfüllkörper 11 hohl mit einem Materialfüllgrad von nicht mehr als 25 % ausgebildet. Dabei ist innerhalb der Hülle 11d eine dreidimensionale Stützstruktur 11e ausgebildet, welche entsprechend nur einen Teil des innenseitigen Volumens der Hülle 11d ausfüllt.

Zur besseren Durchleitung der Hochfrequenzstrahlung ist zusätzlich in dem Ausfüllkörper eine Aussparung 11f ausgebildet, welche sich rotationssymmetrisch um die Längserstreckungsachse x und von der Stirnfläche 11b als Durchbruch durch den gesamten Ausfüllkörper 11 erstreckt. Zusätzlich zur verbesserten Durchleitung der hochfrequenten Strahlung ermöglicht diese Anordnung auch die Vermessung durch einen optischen Sensor 12a, welcher von der Deckenfläche 6d des Behandlungsraums 6 aus auf das Werkstück 3 gerichtet ist. Ein zusätzlicher optischer Sensor 12b ist seitlich im Basisbereich des Behandlungsraums 6 auf das Werkstück 3 ausgerichtet.

In dem Ausführungsbeispiel ist der Ausfüllkörper 11 einstückig ausgebildet und als Ganzes in den Behandlungsraum 6 eingesetzt. Der Ausfüllkörper 11 ist derart an die Form des Werkstücks 3 angepasst, dass eine problemlose Behandlung mit der hochfrequenten elektromagnetischen Strahlung und gleichzeitig Vermessung durch die optischen Sensoren 12a, 12b möglich ist.

Wird die Hochfrequenzbehandlungsanlage erstmalig in Betrieb genommen und/oder auf ein Werkstück 3 von abweichender Geometrie umgestellt, ist im Rahmen des erfindungsgemäßen Verfahrens vorgesehen, dass ein Ausfüllkörper 11 mit einer entsprechend geeigneten Geometrie ausgewählt und/oder hergestellt wird - ganz besonders bevorzugt im Rahmen eines additiven Fertigungsverfahren.

### Bezugszeichenliste

- 1: Hochfrequenzbehandlungsanlage
- 2: Behandlungsstation
- 3: Werkstück
- 3a: Behälterwandung
- 3b: Behälterinnenraum
- 3c: Behältermündung
- 4: Wellenleiter
- 5: Hochfrequenz Generator/Magnetron
- 6: Behandlungsraum/Kavität
- 6a: Grundplatte
- 6b: Oberteil
- 6c: Innenfläche
- 6d: Deckenfläche
- 6e: Verriegelungszapfen
- 7: Werkstückaufnahme/Halte- und Dichtvorrichtung
- 7a: Greifzange
- 7b: Dichtung
- 7c: zentrale Zugangsöffnung
- 8: Konditionierungseinrichtung
- 8a, 8b: Versorgungseinheit
- 8c: Ventilanordnung
- 9: Medienleitung
- 10: Umgebung
- 11: Ausfüllkörper
- 11a: Außenfläche
- 11b: Stirnflächen/weitere Außenfläche
- 11c: Verriegelungsaufnahme
- 11d: Hülle
- 11e: Stützstruktur
- 11f: Aussparung/Durchbruch
- 12a, 12b: optischer Sensor

- x: Längserstreckungsachse
- d: Abstand
- b: Wandstärke

## Patentansprüche

1. Hochfrequenzbehandlungsanlage (1), insbesondere Plasmabehandlungsanlage mit einer Behandlungsstation (2) zur Aufnahme eines Werkstücks (3) und mit einem an die Behandlungsstation (2) angeschlossenen Hochfrequenzgenerator (5) zur Erzeugung einer hochfrequenten elektromagnetischen Strahlung, insbesondere Mikrowellenstrahlung, wobei die Behandlungsstation (2) dazu eingerichtet ist, das Werkstück (3) mit einem Behandlungsraum (6) zu umschließen, in dem Behandlungsraum (6) eine Behandlungskonditionierung einzustellen und das Werkstück (3) unter der Behandlungskonditionierung durch Einwirkung der hochfrequenten elektromagnetischen Strahlung zu behandeln, **dadurch gekennzeichnet, dass** in dem Behandlungsraum (6) zumindest ein Ausfüllkörper (11) angeordnet ist.

2. Hochfrequenzbehandlungsanlage (1) nach dem vorangegangenen Anspruch, **gekennzeichnet durch** eine an die Behandlungsstation (2) angeschlossene Konditionierungseinrichtung (8) zur Einstellung der Behandlungskonditionierung in dem Behandlungsraum (6).

3. Behandlungsstation (2) für eine Hochfrequenzbehandlungsanlage (1) nach einem der vorangegangenen Ansprüche mit einem Behandlungsraum (6) zur Aufnahme und Einhausung eines Werkstücks (3), **gekennzeichnet durch** zumindest einen in dem Behandlungsraum (6) angeordneten Ausfüllkörper (11).

4. Behandlungsstation (2) nach dem vorangegangenen Anspruch, **dadurch gekennzeichnet, dass** der Ausfüllkörper (11) eine Außenfläche (11a) aufweist, welche an eine Innenfläche (6c) des Behandlungsraums (6) geometrisch angepasst ist.

5. Behandlungsstation (2) nach einem der vorangegangenen Ansprüche, **dadurch gekennzeichnet, dass** die Außenfläche (11a) zu der Innenfläche (6c) einen Abstand von weniger als 10 mm, vorzugsweise weniger als 5 mm, insbesondere weniger als 1 mm aufweist.

6. Behandlungsstation (2) nach einem der vorangegangenen Ansprüche, **dadurch gekennzeichnet, dass** sich, wenn in der Behandlungsstation (2) ein Werkstück angeordnet ist zwischen dem Werkstück (3) und der Innenseite der Behandlungsstation (2) ein Residualvolumen erstreckt und dass der Ausfüllkörper (11) zumindest 10 %, vorzugsweise zumindest 50 %, besonders bevorzugt zumindest 75 %, insbesondere zwischen 80 % und 90 % des Residualvolumens ausfüllt.

7. Behandlungsstation (2) nach einem der vorangegangenen Ansprüche, **dadurch gekennzeichnet, dass** in dem Behandlungsraum (6) einseitig eine Werkstückaufnahme (7), insbesondere ein Halte- und Dichtvorrichtung, angeordnet ist zur Aufnahme des Werkstücks (3) und dass der Ausfüllkörper (11) an der der Werkstückaufnahme (7) gegenüberliegenden Seite des Behandlungsraums (6) angeordnet ist.

8. Behandlungsstation (2) nach einem der vorangegangenen Ansprüche, **dadurch gekennzeichnet, dass** der Ausfüllkörper (11) formschlüssig, insbesondere durch einen Bajonettverschluss in der Behandlungsstation (2) befestigt ist.

9. Behandlungsstation (2) nach einem der vorangegangenen Ansprüche, **dadurch gekennzeichnet, dass** der Ausfüllkörper (11) starr ausgebildet ist.

10. Behandlungsstation (2) nach einem der vorangegangenen Ansprüche, **dadurch gekennzeichnet, dass** der Ausfüllkörper (11) hohl ausgebildet ist.

11. Behandlungsstation (2) nach einem der vorangegangenen Ansprüche, **dadurch gekennzeichnet, dass** der Ausfüllkörper aus zumindest einem nicht-leitenden Material, vorzugsweise einem Kunststoffmaterial, insbesondere POM oder PEEK gebildet ist.

12. Behandlungsstation (2) nach einem der vorangegangenen Ansprüche, **dadurch gekennzeichnet, dass** der Ausfüllkörper (11) eine geschlossene Hülle (11d), insbesondere mit einer Wandstärke (b) zwischen 1 mm und 5 mm aufweist und dass der Ausfüllkörper innerhalb der Hülle (11d) hohl mit einem Materialfüllgrad von nicht mehr als 25 %, vorzugsweise nicht mehr als 10 % ausgebildet ist

13. Behandlungsstation (2) nach einem der vorangegangenen Ansprüche, **dadurch gekennzeichnet, dass** der Ausfüllkörper (11) eine Stützstruktur und eine materialverschiedene die Stützstruktur umschließende Beschichtung aufweist.

14. Behandlungsstation (2) nach einem der vorangegangenen Ansprüche, **dadurch gekennzeichnet, dass** der Ausfüllkörper (11) zumindest eine Aussparung (11f) aufweist.

15. Behandlungsstation (2) nach einem der vorangegangenen Ansprüche, **dadurch gekennzeichnet, dass** der Ausfüllkörper (11) mehrteilig modular mit zumindest einem ersten Ausfüllmodul und einem zweiten Ausfüllmodul gebildet ist.

16. Behandlungsstation (2) nach dem vorangegangenen Anspruch, **dadurch gekennzeichnet, dass** das erste Ausfüllmodul und das zweite Ausfüllmodul aneinander anliegen und vorzugsweise aneinander befestigt sind.

17. Verfahren zum Einrichten einer Hochfrequenzbehandlungsanlage (1) insbesondere nach einem der Ansprüche 1 oder 2 mit einer Behandlungsstation (2) nach einem der vorangegangenen Ansprüche mit einem Behandlungsraum (6) zur Aufnahme eines Werkstücks (3), **dadurch gekennzeichnet, dass** in Abhängigkeit von der Geometrie des Werkstücks (3) zumindest ein Ausfüllkörper (11) ausgewählt und/oder hergestellt wird und anschließend in den Behandlungsraum (6) eingesetzt wird.
